Europäisches Patentamt

European Patent Office

Office européen des brevets

(11) Numéro de publication : **0 413 625 B1**

## (12) FASCICULE DE BREVET EUROPEEN

(45) Date de publication du fascicule du brevet :
13.10.93 Bulletin 93/41

(51) Int. Cl.⁵ : **H03F 3/193, H03F 1/34**

(21) Numéro de dépôt : **90402236.5**

(22) Date de dépôt : **03.08.90**

(54) **Amplificateur à haut rendement.**

(30) Priorité : **18.08.89 FR 8911025**

(43) Date de publication de la demande :
**20.02.91 Bulletin 91/08**

(45) Mention de la délivrance du brevet :
**13.10.93 Bulletin 93/41**

(84) Etats contractants désignés :
**DE GB NL**

(56) Documents cités :
**EP-A- 0 033 198**
**US-A- 4 467 288**

(73) Titulaire : **THOMSON-CSF
SEMICONDUCTEURS SPECIFIQUES
51 Esplanade du Général de Gaulle
F-92800 Puteaux (FR)**

(72) Inventeur : **Camiade, Marc
THOMSON-CSF, SCPI, Cédex 67
F-92045 Paris la Défense (FR)**
Inventeur : **Gayral, Michel
THOMSON-CSF, SCPI, Cédex 67
F-92045 Paris la Défense (FR)**

(74) Mandataire : **Taboureau, James et al
THOMSON-CSF, SCPI, B.P. 329, 50, rue
Jean-Pierre Timbaud
F-92402 Courbevoie Cédex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne la structure d'un amplificateur, et notamment celle d'un amplificateur hyperfréquence. Elle constitue un perfectionnement destiné à augmenter le rendement électrique de l'amplificateur.

L'augmentation du rendement électrique des amplificateurs à transistors à effet de champ devient indispensable pour les systèmes électroniques actuels et futurs, en raison de l'augmentation du nombre de circuits. Cette amélioration des performances passe par :

- l'amélioration de la technologie de réalisation des transistors,
- la diminution des pertes des circuits passifs d'adaptation,
- l'optimisation du point de polarisation des transistors, en changeant de classe de fonctionnement.

C'est sur ce dernier point que porte l'invention définie dans la revendication 1.

On sait que les caractéristiques d'un transistor polarisé en dessous de sa tension de pincement ne sont pas reproductibles. Elles dépendent de la technologie de réalisation du composant, et ne sont garantis par aucun constructeur.

Mais on sait également que si une tension très supérieure en valeur absolue est appliquée sur la grille d'un transistor à effet de champ, celui-ci est soumis à une sorte d'hystérésis : lorsque la tension grille revient dans une valeur comprise entre la tension de pincement et la tension maximale de grille, le transistor ne répond pas immédiatement. Il reste bloqué un certain temps, pendant lequel le signal d'entrée n'est pas amplifié, ce qui correspond donc à une diminution de rendement et à une inutile dissipation d'énergie.

L'objet de l'invention est donc d'introduire dans la structure d'un amplificateur des moyens qui limitent la tension appliquée sur la grille à des valeurs comprises entre la tension de pincement et la tension maximale de grille, de sorte que le transistor fonctionne en permanence selon des caractéristiques parfaitement contrôlées. Cette limitation de la tension appliquée sur la grille peut être obtenue de différentes façons, au moyen d'une diode qui constitue un court-circuit pour la phase négative du signal, ou au moyen d'un circuit de contre-réaction à l'harmonique 2.

De façon, plus précise, l'invention concerne un amplificateur à haut rendement, comportant au moins un transistor à effet de champ, un quadrupôle d'entrée d'adaptation du signal d'entrée, relié à la grille du transistor, et un quadrupôle de sortie relié au drain du transistor dont la source est à la masse, cet amplificateur étant caractérisé en ce qu'il comporte des moyens de limitation de l'excursion de la tension appliquée sur la grille à des valeurs comprises entre la tension de pincement $V_P$ du transistor et la tension maximale positive de grille $V_{GS\,max}$.

L'invention sera mieux comprise par la description qui suit de deux exemples de réalisation, qui sont exposés en relation avec les figures jointes en annexe, qui représentent :

- figure 1 : courbes des caractéristiques statiques d'un transistor à effet de champ, selon l'art connu,
- figure 2 : schéma synoptique d'un amplificateur muni d'un premier moyen d'amélioration du rendement selon l'invention,
- figure 3 : courbes de la tension appliqué sur la grille, dans le cas du montage de la figure précédente.
- figure 4 : schéma synoptique d'un amplificateur muni d'un second moyen d'amélioration du rendement, selon l'invention
- figure 5 : forme de la tension appliquée sur la grille, dans le cas du montage de la figure précédente.

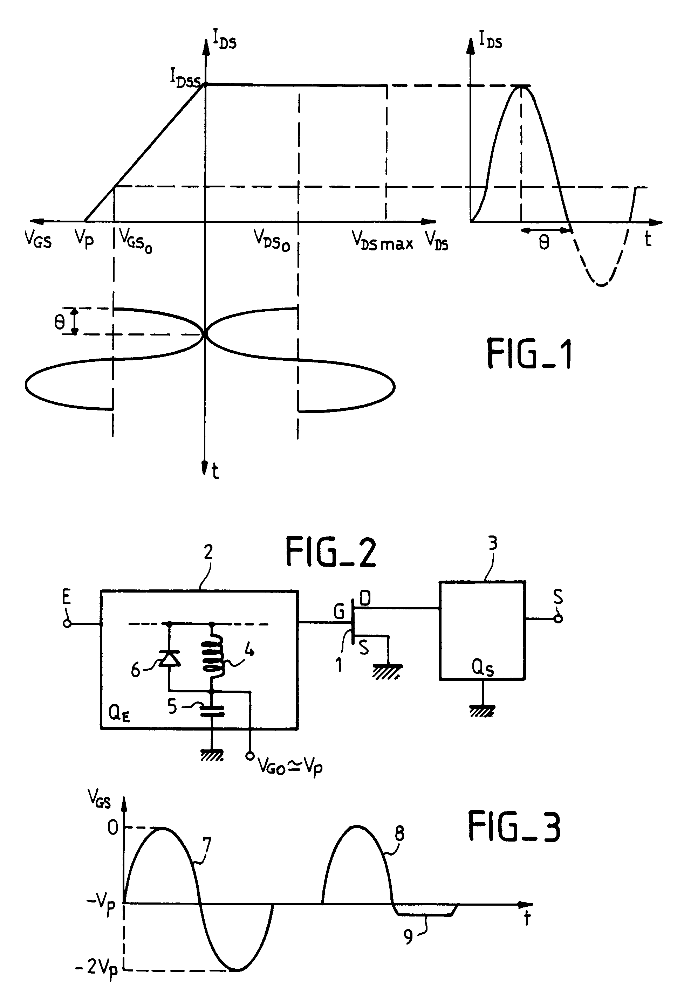

La figure 1 représente les caractéristiques statiques simplifiées d'un transistor : elle donne le comportement temporel des tensions et courants lorsqu'une tension

$$V_{GS} = V_{GS0} + V_{GS1}\cos\omega t$$

est appliquée entre la grille et la source. Sur cette figure sont représentés :

- $I_{DS}$ = courant drain-source
- $V_{DS}$ = tension drain-source
- $V_{GSo}$ = tension continue de polarisation de grille
- $V_{DSo}$ = tension continue de polarisation de drain
- $V_P$ = tension de pincement
- $t$ = temps

$\theta$ représente, pour un signal alternatif appliqué sur la grille, l'angle d'ouverture ou de conduction du transistor : il correspond à l'intervalle de temps pendant lequel le courant de drain $I_{DS}$ est non nul (à droite sur la figure).

Le rendement électrique d'un transistor peut s'exprimer de deux façons.

Le rendement drain $\eta_D$ est égal au rapport de la puissance de sortie à la fréquence d'utilisation sur la puissance injectée par les générateurs continus :

$$\eta_D = \frac{P_S(\omega)}{P_{DC}}$$

Ce rendement est d'autant plus grand que l'angle d'ouverture est faible.

Le rendement en puissance ajoutée $\eta_{aj}$ en dérive en tenant compte de la puissance injectée à l'entrée du transistor à la fréquence :

$$\eta_{aj} = \frac{P_S(\omega) - P_E(\omega)}{P_{DC}}$$

$\eta_{aj}$ est une fonction du gain G du transistor :

$$\eta_{aj} = \eta_D \left(1 - \frac{1}{G}\right)$$

L'objectif recherché est d'augmenter le rende-

ment en puissance ajoutée $\eta_{aj}$, mais cette optimisation se heurte à trois limitations.

La première limitation concerne la dépendance du rendement par rapport au gain. Pour que le rendement drain $\eta_D$ augmente, donc que l'angle d'ouverture diminue, il faut appliquer à la grille du transistor une tension plus élevée, donc une puissance d'entrée $P_E(\omega)$ plus élevée, qui diminue $\eta_{aj}$. Il y a donc un angle d'ouverture $\theta$ optimum pour un transistor.

La deuxième limitation provient du fonctionnement du transistor en dessous de sa tension de pincement. En effet, comme il a été dit précédemment, les caractéristiques d'un transistor dans cette zone de fonctionnement ne sont garanties par aucun fabricant. Elles dépendent de la technologie de fabrication du transistor et ne sont pas reproductibles. En outre, si le signal d'entrée appliqué sur la grille est très inférieur à la tension de pincement, par exemple - 2 $V_p$ ou 3 $V_p$, le transistor ne reprend pas un fonctionnement normal dès que le signal redevient supérieur à $V_p$ : il y a un certain délai, pendant lequel le transistor ne fonctionne pas, ce qui détériore le rendement.

La troisième limitation concerne également le fonctionnement en dessous de la tension de pincement $V_p$ et est liée au niveau de puissance de sortie. Si l'on considère sur la figure 1 les variations de $V_{GS}$ et de $V_{DS}$ en fonction du temps t, elles sont en opposition de phase. Pour un maximum de puissance de sortie, si la valeur absolue de $V_{GS}$ augmente, l'excursion $V_{GD}$ (tension grille-drain) augmente, mais elle est limitée par un phénomène d'avalanche. On a donc

$$V_{GD\ max} = |V_{GS}| + |V_{DS}| = cste$$

Si $|V_{GS}|$ augmente, pour diminuer l'angle d'ouverture et améliorer le rendement, il faut que $|V_{DS}|$ diminue : dans ce cas la puissance de sortie diminue. L'invention propose deux moyens pour éviter ces trois limitations. Le premier moyen est représenté en figure 2.

On peut considérer qu'un amplificateur est essentiellement un transistor à effet de champ 1. Il fait partie d'un circuit, qu'on peut assimiler à un quadrupôle 2 connecté sur sa grille et à un quadrupôle 3 connecté sur son drain, si le transistor est monté en source commune.

Le signal d'entrée hyperfréquence est appliqué sur l'entrée E de ce quadrupôle, mais une tension de polarisation continue $V_{Go}$, proche de la tension de pincement $V_p$ est également appliquée sur la grille du transistor 1. Généralement, un réseau self 4 - capacité 5 sert de filtre hyperfréquence, pour ne pas perturber l'alimentation continue.

L'invention consiste à insérer dans le réseau d'adaptation d'entrée du transistor 1 une diode 6 montée dans le sens masse vers borne d'entrée. Cette diode met en court circuit tout signal d'entrée lorsque la tension qu'il génère aux bornes de la grille devient inférieure à la tension de pincement $V_p$. En d'autres termes, le réseau d'entrée du transistor 1 ne change pas pendant l'alternance positive de la tension grille, mais devient un court-circuit pendant l'alternance négative.

C'est ce que montre la figure 3. Pour une tension $V_{GS}(t)$ qui varie, par exemple, entre 0 et -2 $V_p$, la courbe 7, sans la diode 6, est une sinusoïde qui a une partie négative. Avec une diode 6, seule subsiste la partie positive 8 de la tension appliquée sur la grille. Seule une fraction 9 de cette tension est un peu plus faible que $V_p$ : cela correspond à la tension de seuil en direct de la diode 6.

Les éléments passifs du quadrupôle d'entrée $Q_E$ sont calculés pour que les harmoniques générés par la diode s'additionnent sur la grille du transistor avec les bonnes phases et amplitudes du signal.

L'avantage de la diode est que la puissance à injecter au transistor est limitée à la région positive du signal d'entrée. Elle est deux fois plus faible avec diode que sans diode. Puisqu'on n'utilise pas le transistor en dessous de sa tension de pincement $V_p$, son comportement est bien connu, et puisque l'amplitude de la tension $V_{GS}$ est la même qu'en classe A, on peut atteindre le maximum de puissance de sortie.

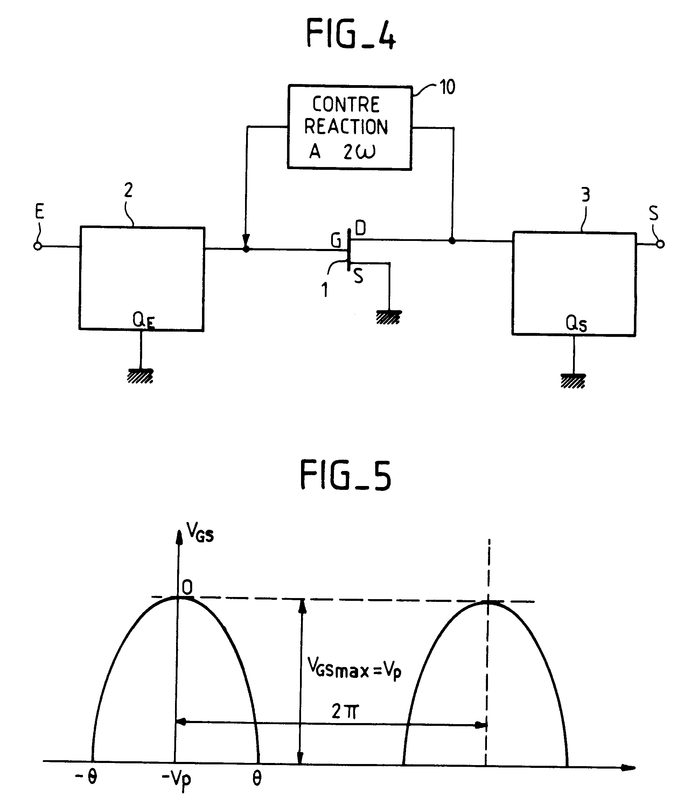

Le second moyen est représenté en figure 4, qui, reprend le schéma simplifié d'un amplificateur constitué d'un transistor 1, avec un quadrupole d'entrée 2 sur sa grille et un quadrupole de sortie 3 sur son drain. Pour améliorer son rendement, on monte une boucle 10 de contre-réaction à l'harmonique 2 entre la sortie et l'entrée du transistor. Cette boucle prélève sur le drain du transistor l'harmonique 2 qui est naturellement produite, et la réinjecte sur la grille. Cette boucle de contre-réaction est en soi connue, et composée de résistances, selfs et capacités.

La tension que l'on veut appliquer sur la grille du transistor a la forme suivante, en série de Fourrier, représentée en figure 5 :

$$V_{GS}(t) = V_p [f_o(\theta) + f_1(\theta) \cos\omega t + f_2(\theta) \cos 2\omega t + ...]$$

dans laquelle :
- $f_o(\theta) V_p$ est l'amplitude de la tension continue de polarisation de grille,
- $f_1(\theta) V_p$ est l'amplitude de la tension à la fréquence $\omega$ générée par la puissance à injecter sur la grille,
- $f_2(\theta) V_p$ est l'amplitude de la tension à la fréquence $2\omega$

Le courant de sortie $I_{DS}$ du transistor n'est pas sinusoïdal : il génère toujours des harmoniques. Il est intéressant de récupérer cette énergie à l'harmonique $2\omega$ et de la réinjecter à l'entrée du transistor.

L'excursion de tension de $V_{GS}$ est limitée, de la même façon qu'avec une diode à l'entrée, mais de plus le circuit de contre réaction à l'harmonique 2 augmente le rendement en puissance ajoutée $\eta_{aj}$ puisqu'on récupère une partie de la puissance de sortie qui est perdue sans contre réaction.

Les deux moyens d'augmentation du rendement d'un ampliflcateur peuvent être utilisés simultanément.

## Revendications

1. Amplificateur à haut rendement, comportant au moins un transistor à effet de champ (1), un quadrupôle d'entrée (2) d'adaptation du signal d'entrée (E), relié à la grille du transistor (1), et un quadrupôle de sortie (3) relié au drain du transistor (1) dont la source est à la masse, cet amplificateur étant caractérisé en ce qu'il comporte des moyens (6,10) de limitation de l'excursion de la tension appliquée sur la grille à des valeurs comprises entre la tension de pincement $V_p$ du transistor (1) et la tension maximale positive de grille $V_{GS\ max}$.

2. Amplificateur selon la revendication 1, caractérisé en ce que le moyen de limitation de la tension appliquée sur la grille est une diode (6), dans le quadrupôle d'entrée (2), qui constitue un court-circuit pour les alternances négatives du signal d'entrée (E).

3. Amplificateur selon la revendication 1, caractérisé en ce que le moyen de limitation de la tension appliquée sur la grille est un circuit (10) de contre-réaction à l'harmonique 2, qui prélève ladite harmonique 2 sur le quadrupôle de sortie (3) et la réinjecte sur le quadrupôle d'entrée (2).

## Patentansprüche

1. Verstärker mit hohem Wirkungsgrad mit wenigstens einem Feldeffekttransistor (1), einem Eingangsvierpol (2) zum Anpassen des Eingangssignals (E), der mit dem Gate-Anschluß des Transistors (1) verbunden ist, und einem Ausgangsvierpol (3), der mit dem Drain-Anschluß des Transistors (1) verbunden ist, dessen Source-Anschluß an Masse liegt, wobei der Verstärker dadurch gekennzeichnet ist, daß er Mittel (6, 10) zum Begrenzen der Abweichung der an den Gate-Anschluß angelegten Spannung auf Werte zwischen der Abschnürspannung Vp des Transistors (1) und der maximalen positiven Gate-Spannung $V_{GSmax}$ enthält.

2. Verstärker nach Anspruch 1, dadurch gekennzeichnet, daß das Mittel zum Begrenzen der an den Gate-Anschluß angelegten Spannung eine Diode (6) in dem Eingangsvierpol (2) ist, die für die negativen Halbperioden des Eingangssignals (E) einen Kurzschluß bildet.

3. Verstärker nach Anspruch 1, dadurch gekennzeichnet, daß das Mittel zum Begrenzen der an den Gate-Anschluß angelegten Spannung eine Gegenkopplungsschaltung (10) bei der zweiten Harmonischen ist, die diese zweite Harmonische vom Ausgangsvierpol (3) abnimmt und in den Eingangsvierpol (2) einspeist.

## Claims

1. High-efficiency amplifier, including at least one field-effect transistor (1), a four-pole input circuit (2) for matching the input signal (E), linked to the gate of the transistor (1), and a four-pole output circuit (3) linked to the drain of the transistor (1) whose source is earthed, this amplifier being characterised in that it includes means (6,10) for limiting the excursion of the voltage applied to the gate to values lying between the pinch-off voltage $V_p$ of the transistor (1) and the maximum positive gate voltage $V_{GS\ max}$.

2. Amplifier according to Claim 1, characterised in that the means of limiting the voltage applied to the gate is a diode (6), in the four-pole input circuit (2), which constitutes a short-circuit for the negative halfcycle of the input signal (E).

3. Amplifier according to Claim 1, characterised in that the means of limiting the voltage applied to the gate is a 2nd-harmonic feedback circuit (10), which picks off the said 2nd harmonic on the four-pole output circuit (3) and reinjects it into the four-pole input circuit (2).

FIG_1

FIG_2

FIG_3

# FIG_4

CONTRE
REACTION
A 2ω

10

E

2

G D

1 S

Q_E

S

3

Q_S

# FIG_5

$V_{GS}$

O

$V_{GSmax} = V_p$

$2\pi$

$-\theta$    $-V_p$    $\theta$